(19) Europäisches Patentamt
European Patent Office
Office européen des brevets

(11) EP 1 635 433 A2

(12) **EUROPEAN PATENT APPLICATION**

(43) Date of publication:
15.03.2006 Bulletin 2006/11

(51) Int Cl.:
*H01S 5/14* (2006.01)

(21) Application number: 05006262.9

(22) Date of filing: 22.03.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 08.09.2004 US 936113

(71) Applicant: Agilent Technologies, Inc.
Palo Alto, CA 94306 (US)

(72) Inventors:
• Trutna, William R. Jr.
Atherton
CA 94027 (US)
• Owen, Geraint
Palo Alto
CA 94303 (US)

(74) Representative: Liesegang, Eva et al
Forrester & Boehmert,
Pettenkoferstrasse 20-22
80336 München (DE)

(54) **Frequency tunable light sources and methods of generating frequency-tunable light**

(57)    Frequency-tunable light sources and methods of generating frequency-tunable light are described. In one aspect, a frequency-tunable light source (10) includes a resonant optical cavity (12), an optical gain medium (18), an optical mode filter (20), and a mode frequency tuner (22). The resonant optical cavity (12) supports oscillation of light in at least one longitudinal mode having a respective mode frequency. The optical gain medium (18) is disposed in the resonant optical cavity (12) and is operable to amplify light. The optical mode filter (20) is arranged to intercept light oscillating in the resonant optical cavity (12) and has an optical transmission pass-band with a tunable center frequency. The mode frequency tuner (22) is arranged to intercept light oscillating in the resonant optical cavity (12) and is operable to tunably change the mode frequencies of the at least one longitudinal mode of the resonant optical cavity (12). In another aspect, a resonant optical cavity (12) is provided. The resonant optical cavity (12) supports oscillation of light in at least one longitudinal mode having a respective mode frequency. Light in at least one longitudinal mode in the resonant optical cavity (12) is amplified. The mode frequencies of the resonant optical cavity (12) are changed. The light is transmission band-pass filtered.

FIG. 3

**Description**

**BACKGROUND**

Many frequency-tunable light sources include a resonant optical cavity that includes an optical gain element and one or more filter elements. The resonant optical cavity quantizes light oscillation to a discrete set of evenly-spaced optical modes most of which are quenched by the filter elements. In many applications, it is desirable to produce a single-wavelength output beam in a single optical mode. It also is desirable to be able to tune the light source continuously without mode hopping over a specified range of frequencies. To achieve this result, the optical modes of the resonant optical cavity and the frequency response of the filter elements of the light source must be tuned synchronously. In addition, the ratio of the filter bandwidth to the optical mode spacing should be relatively small to achieve high mode stability.

There are many different ways to implement a light source that can be tuned in frequency without mode hopping.

In some approaches, a reflector is moved to change the optical length of the optical cavity and, thereby, change the frequencies of the modes of the optical cavity. In order to achieve a practical tuning range with sufficient frequency tuning stability and accuracy, it is necessary to have a reflector moving mechanism that is capable of moving the reflector over a large range (e.g., on the order of 500 micrometers or more) with high precision (e.g., on the order of a few picometers). Such a reflector moving mechanism, however, has yet to be developed.

In other approaches, a pair of acousto-optic devices is used to change the frequencies of the modes of the optical cavity. In these approaches, the acousto-optic deflectors also are used in the process of selecting the mode of the optical cavity. This coupling of functions in the acousto-optical devices increases the difficulty of synchronizing the cavity filtering function and the mode filtering function to achieve frequency tuning without mode hopping.

**SUMMARY**

The invention features frequency-tunable light sources and methods of generating frequency-tunable light. The invention enables the generation of single wavelength output beams that may be rapidly and continuously swept over specified frequency ranges without mode hopping.

In one aspect, the invention features a frequency-tunable light source that includes a resonant optical cavity, an optical gain medium, an optical mode filter, and a mode frequency tuner. The resonant optical cavity supports oscillation of light in at least one longitudinal mode having a respective mode frequency. The optical gain medium is disposed in the resonant optical cavity and is operable to amplify light. The optical mode filter is arranged to intercept light oscillating in the resonant optical cavity and has an optical transmission pass-band with a tunable center frequency. The mode frequency tuner is arranged to intercept light oscillating in the resonant optical cavity and is operable to tunably change the mode frequencies of the at least one longitudinal mode of the resonant optical cavity.

In another aspect, the invention features a method of generating wavelength-tunable light. In accordance with this inventive method, a resonant optical cavity is provided. The resonant optical cavity supports oscillation of light in at least one longitudinal mode having a respective mode frequency. Light in at least one longitudinal mode in the resonant optical cavity is amplified. The mode frequencies of the resonant optical cavity are changed. The light is transmission band-pass filtered.

Other features and advantages of the invention will become apparent from the following description, including the drawings and the claims.

**DESCRIPTION OF DRAWINGS**

FIG. 1 is a block diagram of an embodiment of a frequency-tunable light source.
FIG. 2 is a flow diagram of an embodiment of a method of generating frequency-tunable light.
FIG. 3 is a block diagram of an implementation of the frequency-tunable light source shown in FIG. 1.
FIG. 4A shows exemplary modes of a resonant optical cavity in the implementation of the frequency-tunable light source shown in FIG. 3.
FIG. 4B is a graphical illustration of the spectral features of the implementation of the frequency-tunable light source shown in FIG. 3.
FIG. 5 is a block diagram showing the path of light through the mode frequency tuner of FIG. 3 when the acousto-optic deflectors are driven with respective drive signals at the same frequency.
FIG. 6 is a block diagram showing the path of light through the mode frequency tuner of FIG. 3 when the acousto-optic deflectors are driven with respective drive signals at different frequencies.

FIG. 7 is a block diagram of an alternative implementation of the frequency-tunable light source shown in FIG. 1.
FIG. 8 is a diagrammatic view of an embodiment of a frequency-tunable light source that has a circulating resonant optical cavity.

## DETAILED DESCRIPTION

In the following description, like reference numbers are used to identify like elements. Furthermore, the drawings are intended to illustrate major features of exemplary embodiments in a diagrammatic manner. The drawings are not intended to depict every feature of actual embodiments nor relative dimensions of the depicted elements, and are not drawn to scale.

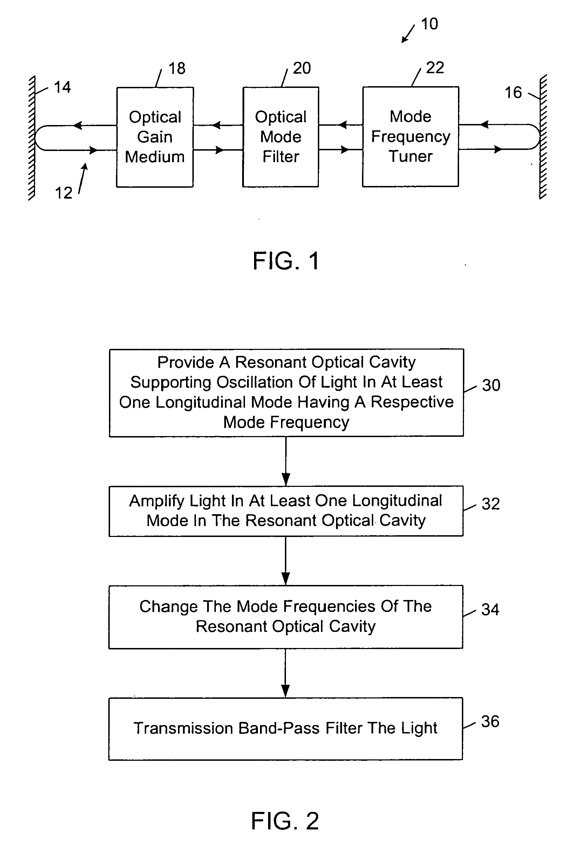

FIG. 1 shows an embodiment of a frequency-tunable light source 10 that includes a resonant optical cavity 12 that is defined between first and second reflectors 14, 16, whose positions are fixed relative to one another. The resonant optical cavity 12 contains an optical gain medium 18, an optical mode filter 20, and a mode frequency tuner 22. The optical gain medium 18 amplifies light that is oscillating in the resonant optical cavity 12. The optical mode filter 20 selects the mode of the optical cavity 12 and the mode frequency tuner 22 sets the actual frequency of the mode. The mode frequency tuner 22 controls the mode frequencies of the resonant optical cavity 12. The optical mode filter 20 selects the optical mode of the resonant optical cavity 12 by quenching all but a limited number of the optical modes within an optical transmission pass band. For example, in some implementations, the optical mode filter 20 has a 3dB bandwidth encompassing at most 10 of the longitudinal modes supported by the resonant optical cavity 12. In this embodiment, the optical transmission band-pass function served by the optical mode filter 20 allows the mode filtering function and the cavity tuning function to be decoupled, making it easier to synchronize the mode filtering and cavity tuning functions to achieve frequency tuning without mode hopping. In addition, the mode frequency tuner 22 tunes the resonant optical cavity 12 without any moving parts and, thereby, avoids the need for a reflector moving mechanism that is capable of moving a reflector over a large range with high precision.

As explained in detail below, in some implementations, the optical mode filter 20 is tuned synchronously with the mode frequency tuner 22 to ensure that light in the resonant optical cavity 12 oscillates the same mode during frequency tuning of the output light. The frequency-tunable light source 10 has two operating modes: a static mode that sets the frequency of the output light; and a dynamic mode in which the frequency of the output light changes from one frequency to another.

The optical gain medium 18 may be any type of optical gain medium that is configured to amplify the light oscillating in the resonant optical cavity 12. For example, in some implementations, the optical gain medium 18 is a semiconductor amplifier, which amplifies light by optically stimulated recombination of holes and electrons in a PN junction. The light emitted from the semiconductor amplifier typically is characterized by a finite spread of photon energy centered close to the bandgap energy of the material of the active region of the semiconductor amplifier. In some of these implementations, one or more collimating lenses are arranged in the resonant optical cavity 12 to transform the output optical beam diverging from the optical gain medium 18 into a parallel optical beam and to focus the return optical beam onto the active region of optical gain medium 18.

The active region of a semiconductor amplifier typically is located between a pair of facets of a semiconductor substrate that are orthogonal to the light path in the resonant optical cavity 12. These facets may include one or more surface treatments, including antireflection coatings and reflective coatings, depending on the arrangement of elements in the resonant optical cavity 12.

The first and second reflectors 14, 16 at least partially reflect the light oscillating in the resonant optical cavity 12. The first and second reflectors 14, 16 are each at least partially reflective of light within the specified optical frequency range of the frequency-tunable light source 10. Exemplary reflectors include a reflective facet of the optical gain medium, a mirror, a diffraction grating, and a retroreflector.

The optical mode filter 20 is any type of optically-transmissive optical band-pass filter whose center frequency is tunable. The optical mode filter 20 may be formed from one or more tunable interference-type filters and tunable absorption-type filters. Exemplary tunable interference-type filters include etalon filters, which are interferometers that have two, often parallel, partially-reflective surfaces that are spaced apart by a spacing defining a narrow pass band by multiple reflection interference. Although the partially-reflective surfaces may both be planar, it is also possible for one or both of these surfaces to be curved. An etalon filter is tuned by varying the spacing between the two reflective surfaces or by varying the index of refraction of the material located between the two reflective surfaces. For example, an air gap etalon may include a gas-filled gap that may be mechanically, thermally, electrically or magnetically actuated to vary one or both of the refractive index of the material filling the gap or the thickness of the gap. Alternatively, an etalon that has an electro-optical medium located between a pair of reflective surfaces may be used. The electro-optical medium has an electrically-tunable refractive index. Alternatively, the optical mode filter 20 may include a birefringent filter that includes a birefringent medium, one or more polarizers, and an element, such as a variable Faraday rotator, that controllably rotates the plane of polarization of the light oscillating in the resonant optical cavity 12. The birefringent medium may be any type of material, such as a Pockels cell or a Kerr cell, which produces a variable optical path length in response to an electrical stimulus or a mechanical stimulus.

The mode frequency tuner 22 may be any type of optical device that can tunably change the mode frequencies of the resonant optical cavity 12. For example, in some implementations, the mode frequency tuner 22 includes one or more acousto-optic devices selected from acousto-optic deflectors, acousto-optic modulators, and acousto-optic tunable filters. Each of these types of acousto-optic devices imposes a Doppler frequency shift on the light oscillating in the resonant optical cavity. The direction of the frequency shift depends on the propagation direction of the acoustic waves in the acousto-optic device with respect to the propagation direction of the light. In some implementations of the frequency-tunable light source 10, the mode frequency tuner 22 includes first and second acousto-optic devices. The first acousto-optic device is operable to impose a Doppler shift on the mode frequencies of light oscillating in the resonant optical cavity and the second acousto-optic device is operable to impose a second Doppler shift in the mode frequencies of light oscillating in the resonant optical cavity, wherein the first and second Doppler shifts are in opposite directions.

The difference between the drive frequencies that are applied to the first and second acousto-optic devices controls the time rate of change of the mode frequencies of the resonant optical cavity 12.

In a static mode of operation, the RF drive signals to the mode tuning filter 22 are equal in frequency and phase so that the optical frequency of the output light does not change. The center frequency of the optical mode filter 20 also remains static. Therefore, the optical modes within the pass band of the optical mode filter 20 remain fixed in frequency, and only a single optical mode oscillates at a fixed optical frequency in the resonant optical cavity 12.

In a dynamic mode of operation, the optical frequency of the output light changes. In this operational mode, the drive signals to the mode frequency tuner 22 differ in frequency or phase. The modes supported by the resonant optical cavity 12 move up or down in frequency at a constant rate determined by the frequency difference or the phase difference between the drive signals to the mode frequency tuner 22. If the acousto-optic upshifter drive frequency is larger than the acousto-optic downshifter drive frequency, then there is a net frequency upshift on each cavity round trip, and the modes will tune continuously up in frequency. If the acousto-optic downshifter drive frequency is larger than the acousto-optic upshifter drive frequency, then there is a net frequency downshift on each cavity round trip, and the modes will tune continuously down in frequency. In the dynamic mode of operation, the center frequency of the optical mode filter 20 changes to track the changing mode frequency so that the optical frequency of the output light may be increased and decreased without mode hopping. The dynamic mode covers two operational modes, namely, a chirp mode in which the output light undergoes a frequency sweep and a tuning mode in which the output light is changed in frequency from one static frequency to another static frequency.

FIG. 2 shows an embodiment of a method by which the frequency-tunable light source 10 generates frequency-tunable light. A resonant optical cavity supporting oscillation of light in at least one longitudinal mode having a respective mode frequency is provided (block 30). The optical gain medium 18 amplifies light in at least one longitudinal mode in the resonant optical cavity (block 32). The mode frequency tuner 22 changes the mode frequencies of the resonant optical cavity (block 34). The optical mode filter 20 transmissively band-pass filters the light in the resonant optical cavity (block 36). The optical transmission pass band of the optical mode filter 20 typically has a center frequency that substantially corresponds to a target optical frequency of the light.

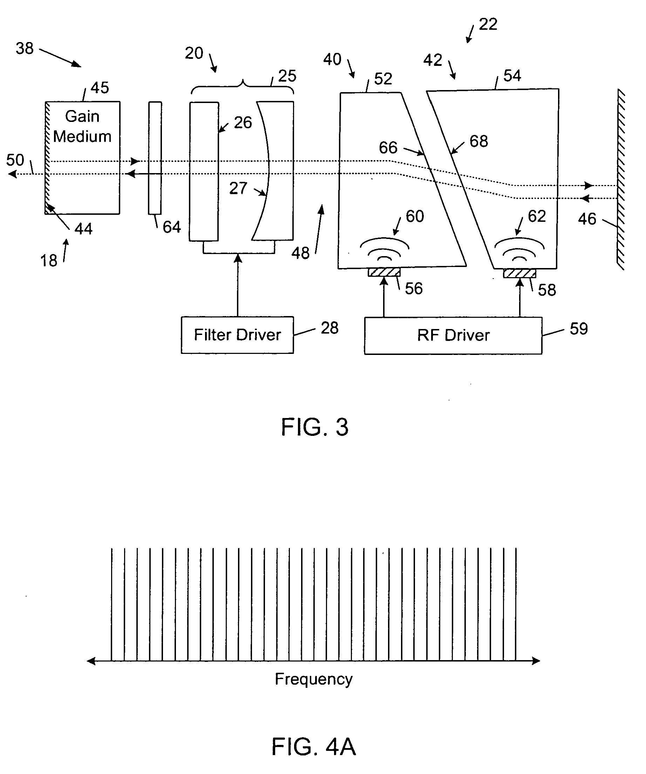

FIG. 3 shows an implementation 38 of the frequency-tunable light source 10 in which the optical mode filter 20 includes a Fabry-Perot etalon 25, the mode frequency tuner 22 is implemented by a pair of acousto-optic deflectors 40, 42, a reflective facet 44 of a semiconductor amplifier optical gain medium 45 provides the first reflector 14, and a mirror 46 provides the second reflector 16. The facet 44 and the mirror 46 define a resonant optical cavity 48 having the Fabry-Perot etalon 25, the pair of acousto-optic deflectors 40, 42, and a lens 64. The resonant optical cavity 48 supports oscillation of light in at least one longitudinal mode. In this embodiment, the mirror 46 has a high reflectively, whereas the reflective facet 44 is partially reflective to allow a portion of the light oscillating in resonant optical cavity 48 to exit in the form of an output beam 50.

The Fabry-Perot etalon 25 of the optical mode filter 20 has first and second closely spaced, partially reflective surfaces 26, 27. Part of the light is transmitted each time the light reaches the first and second surfaces 26 and 27, resulting in multiple beams that interfere with each other to produce an interferometer with a high resolution. Surface 26 is shown as being planar and surface 27 as being concave for the sake of illustration. However, in practice, either surface or both surfaces may be planar, concave or convex. A filter driver 28 adjusts the spacing between the reflectors 26, 27 to adjust the center frequency of the pass band of Fabry-Perot etalon 25. In some implementations, the Fabry-Perot etalon 25 is part of a MEMS (micro-electro-mechanical system) or a MOEMS (micro-opto-electro-mechanical system), as described in, for example, any one of the following U.S. patents: U.S. Patent No. 6,339,603; U.S. Patent No. 6,345,059; U.S. Patent No. 6,282,215; and U.S. Patent No. 6,526,071.

In some implementations, a quarter-wave plate is placed on each side of the optical mode filter 20 to counteract reflections from the reflective surfaces of the Fabry-Perot etalon 25.

Each of the acousto-optic deflectors 40, 42 includes a respective birefringent crystal substrate 52, 54 (e.g., tellurium dioxide or lithium niobate) and a respective electro-mechanical transducer 56, 58. Each transducer 56, 58 may be implemented by, for example, a single piezoelectric transducer or an array of piezoelectric transducers. The transducers 56, 58 may be driven by a single RF driver 59, as shown in FIG. 3, or by multiple respective RF drivers. The transducers 56, 58 are coupled to the one or more RF drivers by a matching network (not shown). In response to received RF drive signals, the transducers 56, 58 respectively generate acoustic waves 60, 62 in the birefringent crystal substrates 52, 54 at an acoustic frequency corresponding to the frequency of the RF drive signals.

The first acousto-optic deflector 40 is arranged to intercept light propagating in the resonant optical cavity 48, and is operable to deflect the intercepted light and to impose a first Doppler shift on the frequencies of the longitudinal modes of the resonant optical cavity 48. The second acousto-optic deflector 42 is arranged to intercept light propagating in the resonant optical cavity 48, and is operable to deflect the intercepted light and to impose a second Doppler shift on the frequencies of the longitudinal modes of the resonant optical cavity 48. The first and second Doppler shifts are in opposite directions. In the illustrated embodiment, the first and second acousto-optic deflectors 40, 42 deflect the intercepted light by substantially equal and opposite angles to produce substantially zero net angular deflection of the intercepted light, as shown in FIG. 3. In this way, the oscillating light beam is always substantially perpendicular to the surface of the mirror 46 even though the light beam is incident at different locations across the surface of the first mirror 46, depending on the frequencies of the drive signals that are applied to the first and second acousto-optic deflectors 40, 42.

In operation, the optical gain medium 45 amplifies light. The light diverges toward the lens 64, which transforms the light into a parallel beam. The optical mode filter 20 subjects the parallel beam to a narrow filter pass band that contributes to the overall resistance of the light source 38 to mode hopping. The filtered beam enters the first acousto-optic deflector 40, which deflects the beam towards the transducer 56 and downshifts the frequency of the filtered beam by an amount corresponding to the acoustic frequency of the acoustic waves 60. The deflected and upshifted beam exits the planar face 66 of the first acousto-optic deflector 40. The deflected beam then passes into the planar face 68 of the second acousto-optic deflector 42. The second acousto-optic deflector 42 deflects the beam away from the transducer 58 and upshifts the frequency of the beam by an amount corresponding to the acoustic frequency of the acoustic waves 62. In some operational modes, the second acousto-optic deflector 42 is driven in such a way as to substantially cancel the spectral shifting of the light beam by the first acousto-optic deflector 40. The mirror 46 intercepts the beam deflected by the second acousto-optic deflector 42 and reflects the intercepted beam back toward the second acousto-optic deflector 42.

On the return trip, the light beam traverses the same light beam path 48 back to the optical gain medium 18. The lens 64 focuses the parallel return beam onto the active region of the semiconductor amplifier optical gain medium 45. The reflective facet 44 intercepts the return beam and reflects the return beam back toward the lens 64 along the same beam path, thereby completing round-trip of the light in the resonant optical cavity 48. As the reflected light passes through the optical gain medium 45, it is amplified by the optical gain medium 45. The output beam 50 is extracted through the partially reflective facet 44.

The reflective facet 44 and the mirror 46 cause light to propagate back-and-forth in the resonant optical cavity 48. Since the phase of the optical field is continuous after one round trip, the resonant optical cavity 48 constrains the light to a discrete set of resonant optical frequencies namely, the mode frequencies. These mode frequencies are equally spaced by an interval $c/(L)$, where c is the speed of light, and L is the round-trip optical length of the resonant optical cavity 48. FIG. 4A shows an exemplary set of longitudinal modes specified as a function of the wavelength of the oscillating light.

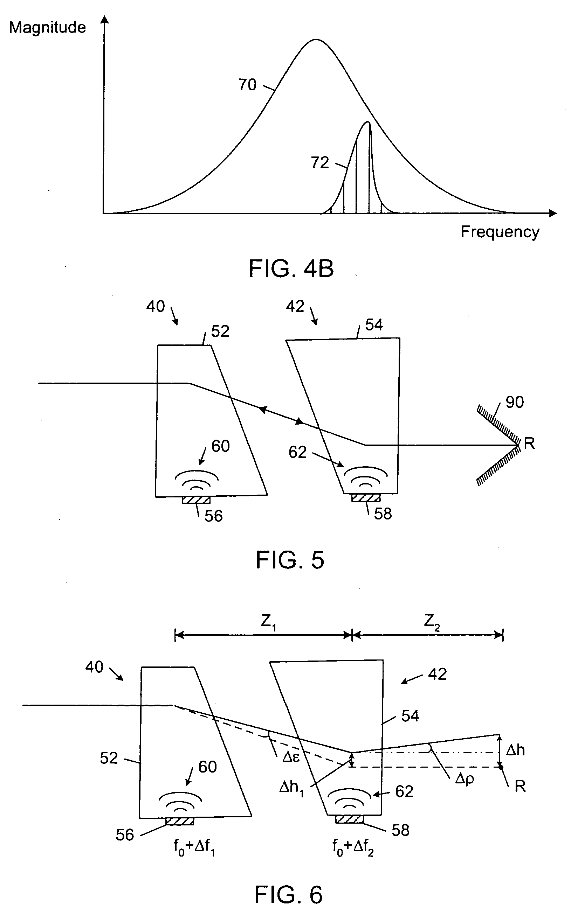

The combined beam deflections by the first and second acousto-optic deflectors 40, 42 and the pass band of the optical mode filter 20 configure the optical path length of the resonant optical cavity 48 such that only a single frequency of light is amplified by the optical gain medium 45. FIG. 4B shows an exemplary plot against optical frequency of the overall gain 70 of the optical gain medium 18. FIG. 4B also shows an exemplary plot against optical frequency of the net optical gain 72 per round trip of optical cavity 48. This net optical gain is the product of the overall gain 70 and the pass band response of the optical mode filter 20. As shown in FIG. 4B, the optical mode filter 20 causes only a narrow band of frequencies to be amplified by the optical gain medium 45. This frequency band encompasses only a limited number of modes, as shown diagrammatically in FIG. 4B. It is often desirable for there to be only one mode within the pass band of the optical mode filter that oscillates in the resonant optical cavity 48 at any given time. The relatively small number of modes (e.g., 1-10 modes) within the pass band of the optical mode filter 20 enhances the ability of the light source 38 to reliably produce output corresponding to a single mode.

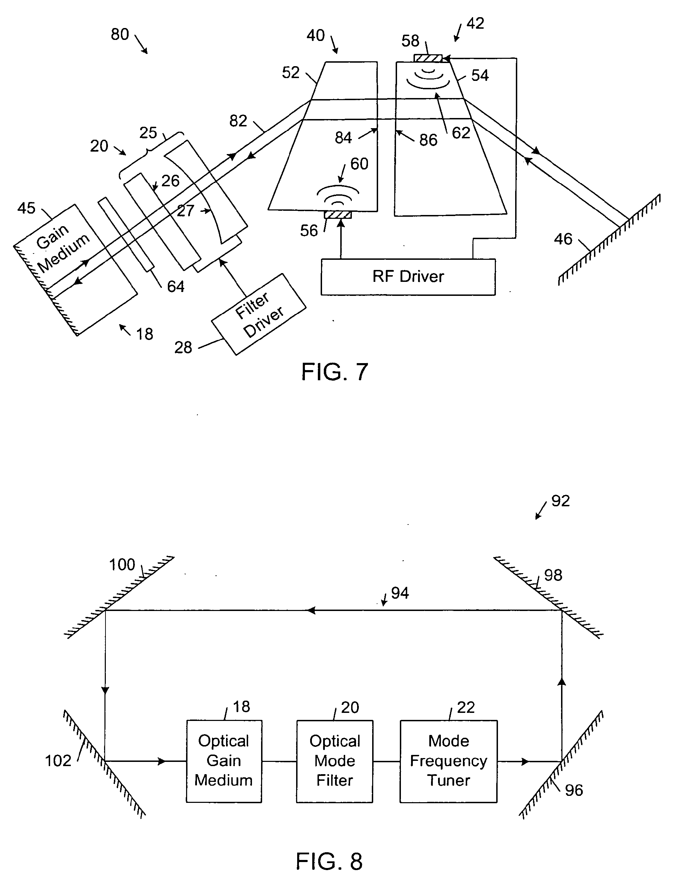

In one dynamic mode of operation, the first and second acousto-optic deflectors 40, 42 allow the mode frequencies to be tuned in a very convenient manner. In particular, the mode frequencies are tuned by applying drive signals at the same acoustic frequency to the first and second transducers 56, 58 and adjusting the phase difference between the drive signals. In optical cavity 48, every $\pi$ radians of phase difference tunes the optical path length of the cavity by a distance corresponding to one mode spacing. In a ring cavity (see, for example, the embodiment shown in FIG. 8), every $2\pi$ radians of phase difference tunes the optical path length by a distance corresponding to one mode spacing.

In another dynamic mode of operation, continuous frequency tuning of the output light is achieved by driving the first and second acousto-optic deflectors 40, 42 at slightly different acoustic frequencies $f_1$ and $f_2$, respectively, to tune the mode frequency of the optical cavity 48. In these implementations, the Doppler frequency shifts of the light imposed by the acousto-optical deflectors 40, 42 do not precisely cancel. If the drive frequencies $f_1$ and $f_2$ are held constant, but different, the mode frequency will ultimately tune outside of the pass band of the optical mode filter 20 and oscillation in another mode will commence. This is undesirable. Thus, in order to achieve continuous tuning, center frequency of the pass band of the optical mode filter 20 is varied to track the changing mode frequency.

As explained above, the frequency-tunable light source 10 can operate in a chirp mode in which the output light undergoes a frequency sweep. For the purpose of the following discussion, the expected free spectral range of the frequency-tunable light source implementation 38 is assumed to be 2 GHz and it is assumed that the light source produces a chirp output with a chirp scan rate of 1000nm/s (or 125 THz/s) when the laser nominal wavelength is 1550 nm. With these parameters, the frequencies of the drive signals that are applied to the first and second acousto-optic deflectors 40, 42 differ by $\Delta f$ = 31.3 kHz in one mode of operation of one particular design. In this mode of operation of this design, the beam deviation at the mirror 46, $\Delta\Phi$, that is caused by a frequency difference $\Delta f$ is given by $\Delta\Phi$ = 0.00254$\Delta f$ (with the angle measured in radians and the frequency difference in MHz). The angular deviation back at the optical gain medium 45 after the round trip is twice this amount.

For the scan rate of 1000 nm/s, $\Delta f$ = 31.3 kHz, and this frequency difference gives rise to a beam divergence of 0.16 mrad (milli-radians) after a round trip in the resonant optical cavity 48. Since the angular acceptance of the semiconductor amplifier optical gain medium 45 typically is $\pm$ 1 mrad, such a beam divergence is acceptable at this scan rate for this design. At scan rates significantly higher than 1000 nm/s, however, the beam deviation becomes significant for this particular design.

Referring to FIG. 5, the beam deviation is at least partially reduced by replacing the mirror 46 (shown in FIG. 3) with a retroreflector 90, which reflects the return beam along a path that is parallel to its outward path. As the optical frequency chirps, however, the return beam will be shifted away from the outward beam, even though the return beam is parallel to the outward beam. As a result, part of the return beam will miss the optical gain medium 45, reducing the optical gain of the system. In many cases, this effect will be negligibly small; however, this may not always be the case. For this reason, in some of these implementations, in addition to changing the acoustic frequency driving the second acousto-optic deflector 42 to generate a chirp, the acoustic frequency driving the first acousto-optic deflector also is changed.

FIGS. 5 and 6 illustrate how the acoustic drive frequency changes may be estimated. FIG. 5 shows the steady state case in which both acousto-optic deflectors 40, 42 are driven at the same acoustic frequency $f_0$ (e.g., $f_0 \approx$ 50 MHz.) The beam leaving the second acousto-optic deflector 42 is therefore parallel to the beam entering the first acousto-optic deflector 40. The retroreflector 90 is placed at the point R.

In FIG. 6, the drive frequencies to the first and second acousto-optic deflectors 40, 42 have been increased by different amounts $\Delta f_1$ and $\Delta f_2$ respectively. As a result, the beam path is deviated by angles $\Delta\varepsilon$ and $\Delta\rho$, these angles being linear functions of the frequency increments $\Delta f_1$ and $\Delta f_2$. As a consequence of the angular deflections, at the retroreflector, the beam is linearly displaced by the distance $\Delta h$.

The drive frequency increments $\Delta f_1$ and $\Delta f_2$ are chosen so as to ensure that $\Delta h$ = 0. This means that they satisfy equation (1):

$$A \times \Delta f_1 + B \times \Delta f_2 = 0 \qquad\qquad (1)$$

where A and B are constants that are determined by the characteristics of the acousto-optic deflectors and the layout of the resonant optical cavity 48. These constants may be calculated or measured.

For a given chirp rate, the difference in acoustic frequencies will have a known value $\Delta f$, so that

$$\Delta f_1 - \Delta f_2 = \Delta f \, . \qquad\qquad (2)$$

For the particular light source design shown in FIG. 3, the solutions of equations (1) and (2) are given by equations (3) and (4):

$$\Delta f_1 = -0.92\Delta f \qqquad\qquad (3)$$

$$\Delta f_2 = -1.92 \Delta f \qquad\qquad (4)$$

Thus, if $f_0$ = 50 MHz and $\Delta f$ = 31.3 kHz, the acoustic frequencies driving the first and second acousto-optic deflectors are 49.9712 MHz and 49.9399 MHz.

FIG. 7 shows an implementation 80 of the frequency-tunable light source 10 that is identical to the implementation 38, except that the orientations of the first and second acousto-optic deflectors 40, 42 are different. In this implementation, the filtered beam 82 enters the first acousto-optic deflector 40, which deflects the beam toward the transducer 56 and downshifts the frequency of the filtered beam by an amount corresponding to the acoustic frequency of the acoustic waves 60. The deflected and downshifted beam exits the planar face 84 of the first acousto-optic deflector 40. The deflected beam then passes into the planar face 86 of the second acousto-optic deflector 42. The second acousto-optic deflector 42 deflects the beam away from the transducer 58 and upshifts the frequency of the beam by an amount corresponding to the acoustic frequency of the acoustic waves 62. In other respects, the operation of the light source 80 is very similar to the operation of the light source 38.

FIG. 8 shows an embodiment of a frequency-tunable light source 92 that includes a circulating (or ring-shaped) resonant optical cavity 94 containing the optical gain medium 18, the optical mode filter 20, the mode frequency tuner 22, and four reflective surfaces 96, 98, 100, 102 defining the resonant optical cavity 94. The components of light source 92 may be implemented in the same way as the corresponding components described above in connection with the wavelength light source 10. The operation of light source 92 is substantially the same as the operation of the frequency-tunable light source 10.

Other embodiments are within the scope of the claims.

## Claims

1. A frequency-tunable light source (10), comprising:

   a resonant optical cavity (12) supporting oscillation of light in at least one longitudinal mode having a respective mode frequency;
   an optical gain medium (18) disposed in the resonant optical cavity (12) and operable to amplify light;
   an optical mode filter (20) arranged to intercept light oscillating in the resonant optical cavity (12) and having an optical transmission pass-band with a tunable center frequency; and
   a mode frequency tuner (22) arranged to intercept light oscillating in the resonant optical cavity (12) and operable to tunably change the mode frequencies of the at least one longitudinal mode of the resonant optical cavity.

2. The frequency-tunable light source of claim 1, wherein the pass band of the optical mode filter (20) has a 3dB bandwidth encompassing at most 10 of the longitudinal modes supported by the resonant optical cavity (12).

3. The frequency-tunable light source of claim 1 or 2, wherein the optical mode filter (20) comprises a tunable optical interference element.

4. The frequency-tunable light source of one of the preceding claims , wherein the mode frequency tuner (22) comprises a first acousto-optic device (40) arranged to intercept light oscillating in the resonant optical cavity (12) and operable to impose a Doppler shift on the mode frequencies of the at least one longitudinal mode of the resonant optical cavity (12), and a second acousto-optic device (42) arranged to intercept light oscillating in the resonant optical cavity (12) and operable to impose a second Doppler shift on the mode frequen-cies of the at least one longitudinal mode of the resonant optical cavity (12), wherein the first and second Doppler shifts are in opposite directions.

5. The frequency-tunable light source of claim 4, further comprising a driver (59) connected to the first and second acousto-optic devices (40, 42), wherein the driver (59) is configured to drive the first and second acousto-optic devices (40, 42) at different respective drive frequencies in one operational mode of the frequency-tunable light source.

6. The frequency-tunable light source of claim 4, further comprising a driver (59) connected to the first and second acousto-optic devices (40, 42), wherein the driver (59) is configured to drive the first and second acousto-optic devices (40, 42) at substantially equal frequencies but with different relative phases in one operational mode of the frequency-tunable light source.

**7.** The frequency-tunable light source of claim 4, further comprising a driver (59) connected to the first and second acousto-optic devices (40, 42), wherein the driver (59) is configured to vary the frequencies of the first and second drive signals in a manner substantially correcting deviation of light by the mode frequency tuner (22) as a result of changing the mode frequencies of the longitudinal modes of the resonant optical cavity (12).

**8.** A method of generating wavelength-tunable light, comprising:

providing a resonant optical cavity (12) supporting oscillation of light in at least one longitudinal mode having a respective mode frequency;
amplifying light in at least one longitudinal mode in the resonant optical cavity (12);
changing the mode frequencies of the resonant optical cavity (12); and
transmission band-pass filtering the light.

**9.** The method of claim 8, wherein changing the mode frequencies of the resonant optical cavity (12) comprises imposing first and second Doppler shifts on the light in opposite directions.

**10.** The method of claim 9, wherein changing the mode frequencies of the resonant optical cavity (12) further comprises imposing the first and second Doppler shifts differing in magnitude by an amount selected to achieve a desired time-dependent variation in the frequency of the light.

/ 10

14

18
Optical
Gain
Medium

20
Optical
Mode
Filter

22
Mode
Frequency
Tuner

16

12

## FIG. 1

Provide A Resonant Optical Cavity
Supporting Oscillation Of Light In At Least
One Longitudinal Mode Having A Respective
Mode Frequency — 30

Amplify Light In At Least One Longitudinal
Mode In The Resonant Optical Cavity — 32

Change The Mode Frequencies Of The
Resonant Optical Cavity — 34

Transmission Band-Pass Filter The Light — 36

## FIG. 2

FIG. 3

FIG. 4A

FIG. 4B

FIG. 5

FIG. 6

FIG. 7

FIG. 8